# EUROPEAN PATENT SPECIFICATION

(11) **EP 2 682 979 B1**
(45) Date of publication and mention of the grant of the patent: **19.06.2019**
(21) Application number: 13275153.8
(22) Date of filing: 03.07.2013
(51) Int. Cl.: H01J 37/32, C23C 16/44

(54) **A method of etching**
Verfahren zum Ätzen
Procédé de gravure

(30) Priority: 03.07.2012 US 201261667443 P; 04.07.2012 GB 201211922
(43) Date of publication of application: 08.01.2014
(73) Proprietor: SPTS Technologies Limited, Newport Gwent NP18 2TA (GB)
(72) Inventor: Burgess, Stephen, Ebbw Vale, Gwent NP23 5NA (GB); Theodosiou, Alex, Caerphilly, CF83 3HA (GB)
(74) Representative: Wynne-Jones IP Limited

(56) References cited:
- EP-A2- 1 619 267
- JP-A- 2000 169 978
- US-A1- 2002 074 014
- US-A1- 2005 258 137
- US-A1- 2011 114 113

## Description

This invention relates to a method of etching successive substrates on a platen in a chamber in which the etching process results in carbonaceous deposits in the chamber.

A number of etching processes may result in carbonaceous deposits in the etched chamber. This is particularly true when processing polyimide (PI) coated silicon wafers, which are widely used in the semi-conductor and other related industries. Prior to metal deposition it is common and desirable to remove material from the wafer surface by a sputter etch process (typically using Ar) in order to ensure a high quality metal/metal interface. This step is normally conducted in a physical vapour deposition (PVD) pre-clean module. However, prolonged or frequent etching of PI wafers through the PVD pre-clean module can lead to a build-up of sputtered material around the chamber lid and walls. This carbonaceous material can accumulate to such a level that particles can become loose and begin to move around the chamber, particularly during processing, and there is the potential for them falling onto and contaminating the wafers.

It is known to seek to combat this problem by frequent use of an oxygen plasma. The oxygen step may be relatively short (e.g. 60s) and act as a conditioning step where no platen bias is required. It is believed that the introduction of an oxygen plasma into a carbonised chamber will promote carbon oxidation, leading to CO/CO₂ which may readily be pumped away. The removal of the material lowers the particle count.

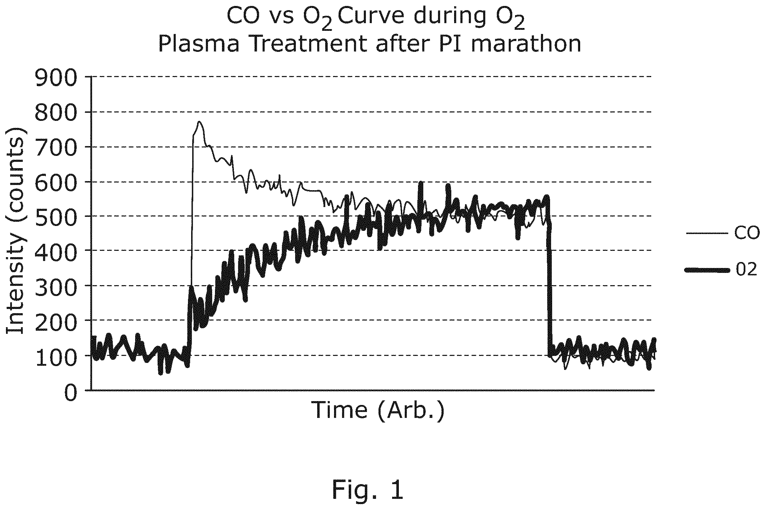

As can be seen in Figure 1, the Applicants have monitored the whole process through optical spectroscopy. During the initial stages of the oxygen plasma, O₂ levels within the chamber are low whilst CO levels appear high. Presumably the Oxygen is converting the carbon species, present from the PI etching, to CO before reaching equilibrium.

The frequency of the oxygen plasma treatment tends to be selected by the customer depending on the rate of particle formation they experience and any other requirements they may have. However, for a typical Ar sputter clean etch where 150-300Å SiO₂ (or equivalent) is removed prior to the subsequent deposition step, it is likely that, within 50 to 100 PI coated wafers, an O₂ plasma clean will be required. Although this process provides effective particle control, that the Applicants have discovered that following such oxygen treatment there is a sharp reduction in etch rate directly afterwards. The drop in etch rate has been measured to be between 20 to 30%. This obviously leads to significant lack of uniformity between successive wafers and many semi-conductor manufacturers would not have accepted this initial drop in etch rate or the resultant drop in throughput, if they had been aware of the problem.

US 2002/074014 describes a method for cleaning a metal etching chamber using waterless auto cleaning followed by an argon clean.

JP 2000 169978 describes a method for cleaning the interior of a reaction chamber using a cleaning gas such as Ar or H₂ after removing a film containing carbon or carbon as a main component.

Herein disclosed is a method of etching successive substrates on a platen in a chamber in which the etching process results in carbonaceous deposits in the chamber, the method including:
(a) interrupting the etch processing of substrates;
(b) running an oxygen of oxygen-containing plasma within the chamber and removing the gaseous by-products; and
(c) resuming the etch processing of substrates.
characterised in that the method further includes the step of:
(d) running an argon plasma in the chamber after step (b) with the platen biased.

In a first aspect of the invention, there is provided a method of etching successive polyimide coated substrates on a platen in an inductively coupled plasma chamber (11) in which the etching process results in carbonaceous deposits in the chamber (11), the method including:
(a) interrupting the etching processing of polyimide coated substrates;
(b) running an oxygen or oxygen containing plasma within the chamber and removing gaseous by-products; and
(c) resuming the etch processing of polyimide coated substrates
characterised in that the method further includes the step of:
(d) running an argon plasma in the chamber after step (b) with the platen (13) biased.

Preferably step (d) lasts for between 500 seconds and 1200 seconds and it is particularly preferred to run step (d) for around 600 seconds.

The platen is preferably RF biased in which case the RF bias power may be between 400 watts and 1000 watts. An RF bias power of about 800w is particularly preferred.

Conveniently the argon plasma is an inductively coupled plasma.

Although the invention has been defined above, it is to be understood that it includes any inventive combination of the features set out above or in the following description.

The invention may be performed in various ways and they will now be described, by way of example, embodiments of the invention with reference to the accompanying drawings, in which:
Figure 1 plot of CO vs O₂ during O₂ plasma treatment after PI processing;

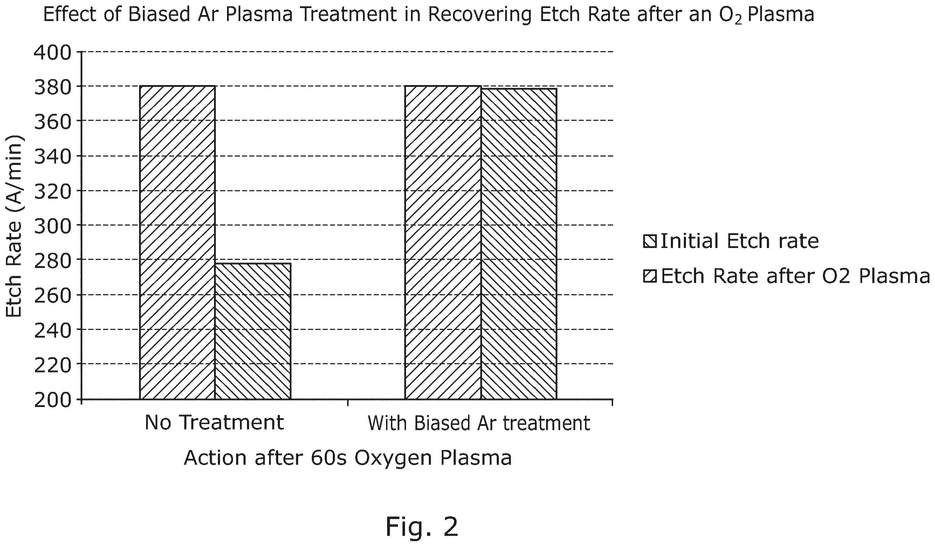

Figure 2 is a plot of etch rates before and after an O₂ plasma treatment where the O₂ plasma treatment is used alone or in combination with a subsequent Ar treatment;

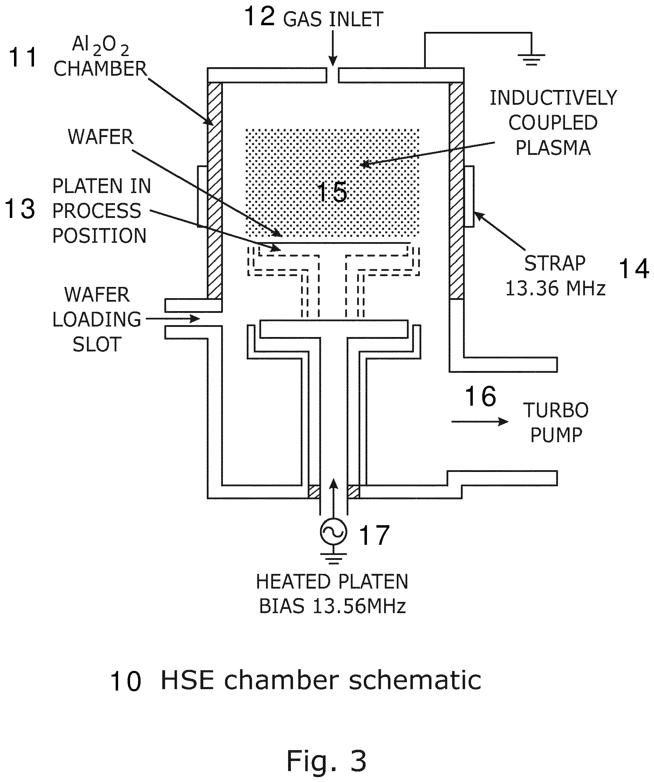

Figure 3 is a schematic view of a PVD chamber utilised in embodiments of the invention;
Figure 4 shows comparative plots of etch rate for certain conditions;
Figure 5 is a plot showing etch rate as a factor of bias or plasma density;

After sputter etching the polyimide wafers with Ar containing plasma the ceramic walls and the chamber lid become coated with carbon deposits which are emitted from the high carbon surface. The carbon deposits are removed by an O₂-based plasma step as previously described. After the oxygen treatment it is likely that some of the oxygen will reside within the internal chamber ceramic and the gas entry point at the top of the chamber; this oxygen may be agitated by the temperature rise during plasma processing and therefore diffuse out into the chamber, altering the nature of the plasma and consequently lowering the etch rate.

The Argon recovery plasma works by exposing the chamber to high temperature and this causes diffusion of oxygen trapped in the chamber body out into the plasma, in the gaseous state. After a certain amount of time enough oxygen will have been removed from the ceramic walls to restore the etch rate to its original value. This process is carried out either with a dummy wafer or on a ceramic-coated platen that is able to be etched.

The Ar sputter etch and the Ar conditioning step have very similar process conditions. The Ar conditioning step would preferably be carried out on a thick ceramic platen (e.g. several mm thick) in order that no conditioning wafer is required.

The etch data of the chamber at a given time can be determined by running a test on a SiO₂ wafer by measuring the thickness before and after of known duration of plasma etch. Results at various stages of Pi processing as shown below.

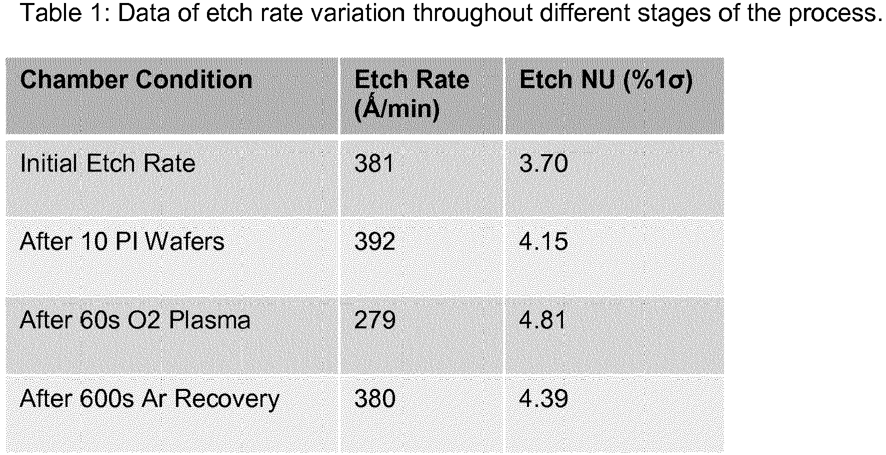

It will be seen that approximately a 30% drop in etch rate results from the oxygen plasma treatment and this can be fully recovered to its original value after a 600 second bias argon recovery plasma.

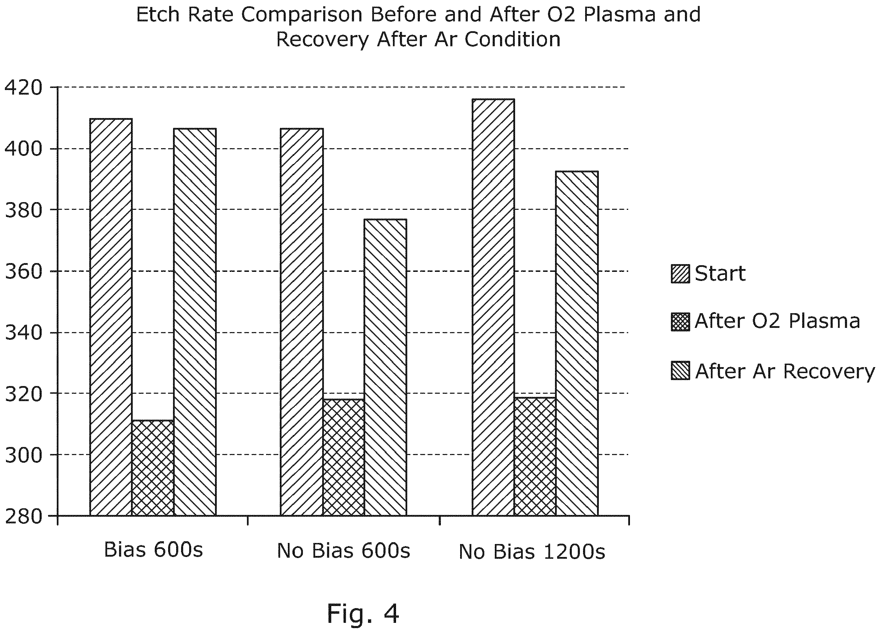

In Figure 4 the significance of the platen bias can be seen with much lower recovery rates if the argon treatment is run without bias.

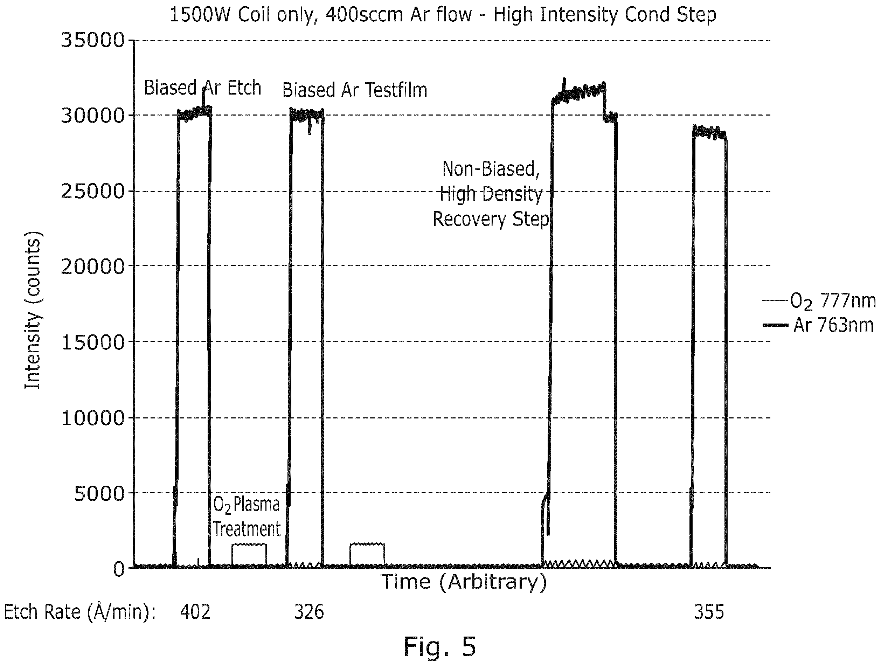

A 600 second bias plasma resulted in a >99% recovery. The etch rate is in general known to be related to the density of the plasma and hence the ion flux at the surface of the wafer. Plasma density can be monitored using an optical microscope to detect the intensity of the light emitted. Typically an optical emission spectrometer is used to detect the intensity of light emitted at various frequencies (e.g. in Fig 5 where O₂=772nm and Ar=763nm) The integrated plasma intensity which is related to rotation flux is typically greater for an unbiased peak than in biased cases. However, when the intensity of a non-biased plasma was increased by increasing the gas flow (600sccm) and coil power (1500w) to match the density of the bias plasma, the etch rate still did not improve.

Figure 5 shows the optical spectrum obtained during Ar and O₂ plasma processing, the high intensity non-biased Ar recovery step is highlighted and the measured etch rates are also displayed.

The plasma intensity observed for the recovery step is slightly higher than the biased argon plasma in this case and yet still the recovering etch rate is not as good as an equivalent biased plasma. It would therefore appear that the platen bias is playing a role separate from increasing plasma intensity in achieving the unexpected etch rate recovery.

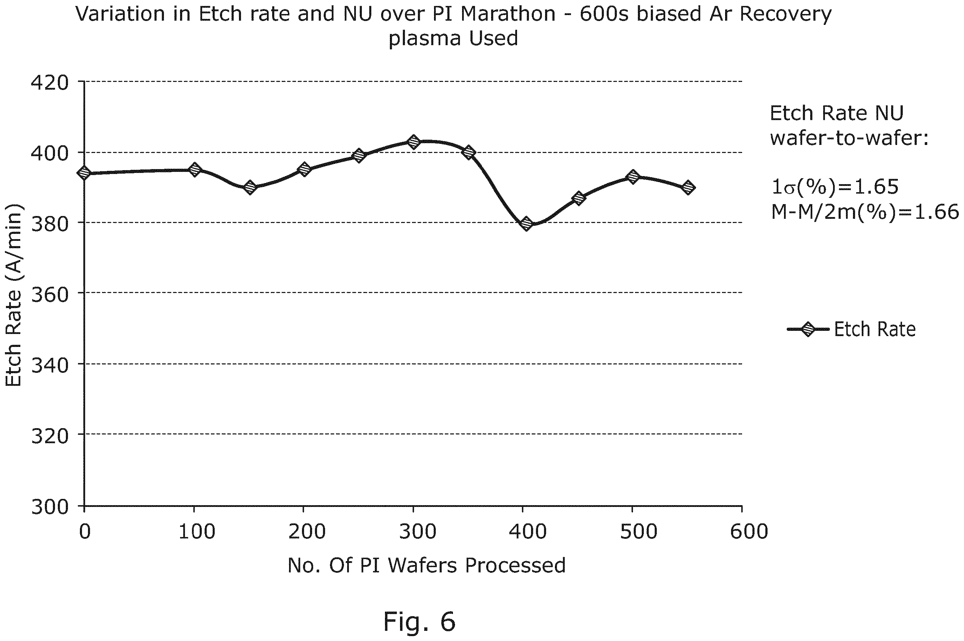

Figure 6 illustrates the stability of etch rate recovery with 600s biased Ar plasma. This shows the results obtained after processing 550pi wafers, with O₂/Ar recovery step occurring after every 50 wafers. The etch rate has a wafer to wafer non-uniformity 1σ(%) of 1.65 which is within most customer specifications.

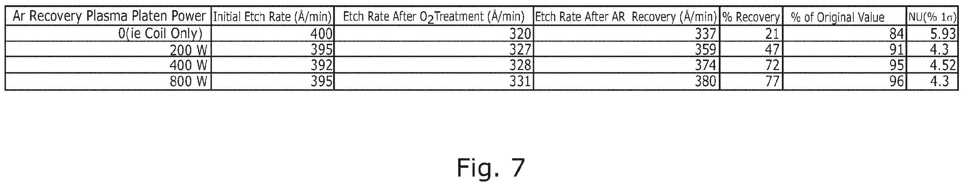

The table in Figure 7 illustrates the relationship between recovery and bias. Increasing bias improves the rate of recovery but between 400 and 800 watts the increase in improvement is limited and a preferred process would run at 600 watts.

## Claims

1. A method of etching successive polyimide coated substrates on a platen (13) in an inductively coupled plasma chamber (11) in which the etching process results in carbonaceous deposits in the chamber (11), the method including:
(a) interrupting the etching processing of polyimide coated substrates;
(b) running an oxygen or oxygen containing plasma within the chamber (11) and removing gaseous by-products; and
(c) resuming the etch processing of polyimide coated substrates
**characterised in that** the method further includes the step of:
(d) running an argon plasma in the chamber (11) after step (b) with the platen (13) biased.

2. A method as claimed in claim 1 wherein step (d) lasts for between 500 seconds and 1200 seconds.

3. A method as claimed in claim 2 wherein step (d) lasts for about 600 seconds.

4. A method as claimed in any one of the preceding claims wherein the platen (13) is RF biased.

5. A method as claimed in claim 4 wherein the RF bias power is between 400w and 1000w.

6. A method as claimed in claim 5 wherein the RF bias power is about 800w.

7. A method as claimed in any one of the preceding claims wherein the Argon plasma is an inductively coupled plasma.

## Patentansprüche

1. Verfahren zum Ätzen von aufeinanderfolgenden Polyimid-beschichteten Substraten auf einer Trägerplatte (13) in einer induktiv gekoppeltes Plasma-Kammer (11), wobei der Ätzvorgang zu Kohlenstoff-enthaltenden Abscheidungen in der Kammer (11) führt, wobei das Verfahren umfasst:
(a) Unterbrechen der Ätzverarbeitung von Polyimid-beschichteten Substraten;
(b) Bereitstellen eines Sauerstoff-Plasmas oder eines Sauerstoff-enthaltenden Plasmas innerhalb der Kammer (11) und Entfernen von gasförmigen Nebenprodukten; und
(c) Fortsetzen der Ätzverarbeitung von Polyimid-beschichteten Substraten,
**dadurch gekennzeichnet, dass** das Verfahren ferner den Schritt umfasst:
(d) Bereitstellen eines Argon-Plasmas in der Kammer (11) nach dem Schritt (b), wobei die Trägerplatte (13) unter Vorspannung gesetzt ist.

2. Verfahren nach Anspruch 1, bei dem der Schritt (d) zwischen 500 Sekunden und 1200 Sekunden dauert.

3. Verfahren nach Anspruch 2, bei dem der Schritt (d) etwa 600 Sekunden dauert.

4. Verfahren nach einem der vorhergehenden Ansprüche, bei dem die Trägerplatte (13) unter HF-Vorspannung gesetzt ist.

5. Verfahren nach Anspruch 4, bei dem die HF-Vorspannungsleistung zwischen 400 W und 1000 W beträgt.

6. Verfahren nach Anspruch 5, bei dem die HF-Vorspannungsleistung etwa 800 W beträgt.

7. Verfahren nach einem der vorhergehenden Ansprüche, bei dem das Argon-Plasma ein induktiv gekoppeltes Plasma ist.

## Revendications

1. Procédé de gravure de substrats revêtus de polyimide successifs sur une platine (13) dans une chambre de plasma couplé par induction (11) dans laquelle le traitement de gravure résulte en des dépôts carbonés dans la chambre (11), le procédé comprenant :
(a) interrompre le traitement de gravure de substrats revêtus de polyimide ;
(b) acheminer de l'oxygène ou un plasma contenant de l'oxygène à l'intérieur de la chambre (11) et retirer des sous-produits gazeux ; et
(c) reprendre le traitement de gravure de substrats revêtus de polyimide,
**caractérisé par le fait que** le procédé comprend en outre l'étape :
(d) acheminer un plasma d'argon dans la chambre (11) après l'étape (b) avec la platine (13) polarisée.

2. Procédé selon la revendication 1, dans lequel l'étape (d) dure entre 500 secondes et 1200 secondes.

3. Procédé selon la revendication 2, dans lequel l'étape (d) dure environ 600 secondes.

4. Procédé selon l'une quelconque des revendications précédentes, dans lequel la platine (13) est polarisée en radiofréquence.

5. Procédé selon la revendication 4, dans lequel la puissance de polarisation radiofréquence est comprise entre 400 w et 1000 w.

6. Procédé selon la revendication 5, dans lequel la puissance de polarisation radiofréquence est d'environ 800 w.

7. Procédé selon l'une quelconque des revendications précédentes, dans lequel le plasma d'argon est un plasma couplé par induction.
